# EUROPÄISCHE PATENTSCHRIFT

(11) **EP 0 562 388 B1**
(45) Veröffentlichungstag und Bekanntmachung des Hinweises auf die Patenterteilung: **29.07.1998**
(21) Anmeldenummer: 93104018.2
(22) Anmeldetag: 12.03.1993
(51) Int. Cl.: G06K 19/077, H01L 23/498

(54) **Herstellverfahren und Herstellvorrichtung für Trägerelemente mit IC-Bausteinen in Ausweiskarten**
Manufacturing method and apparatus for carrier elements with IC modules in ID-cards
Procédé et dispositif de fabrication d'éléments porteurs de circuits intégrés dans des cartes d'identification

(30) Priorität: 21.03.1992 DE 4209184
(43) Veröffentlichungstag der Anmeldung: 29.09.1993
(73) Patentinhaber: Orga-Kartensysteme GmbH, 33104 Paderborn (DE)
(72) Erfinder: Blome, Rainer, 33106 Paderborn (DE)
(74) Vertreter: Hanewinkel, Lorenz, Dipl.-Phys.

(56) Entgegenhaltungen:
- EP-A- 0 344 058
- EP-A- 0 426 406
- US-A- 4 218 701
- PATENT ABSTRACTS OF JAPAN vol. 8, no. 091 (E-241)26. April 1984 & JP-A-59 010 241 ( HITACHI ) 19. Januar 1984
- PATENT ABSTRACTS OF JAPAN vol. 14, no. 355 (M-1004)31. Juli 1990 & JP-A-2 125 720 ( I S KOGYO DESIGN ) 14. Mai 1990

## Beschreibung

Die Erfindung betrifft ein Trägerelement aus einem kontaktkaschierten Folienmaterial mit einem aufgekitteten und mit Kunststoff umgebenen IC-Baustein, der in eine Ausnehmung einer Ausweiskarte unter Freilassung eines allseitigen Spaltes einbaubar ist, wobei die kontaktkaschierte Folie des Trägerelements die Ausnehmung randseitig überlappt, sowie eine Herstellvorrichtung dafür und ein damit hergestellte Ausweiskarte.

Ein derartiges Trägerelement ist aus der US-PS 5,027,190 bekannt. Dieses besteht aus einem isolierenden Trägermaterial mit aufkaschierten metallischen Kontakten, auf denen in einer Ausnehmung des isolierenden Materials der elektronische IC-Baustein befestigt ist. Auf dem Isoliermaterial ist eine heißsiegel-Klebstoffschicht mit einer Ausnehmung um den IC-Baustein aufgebracht. Ein Epoxidharztropfen überwölbt die Ausnehmungen und schließt den IC-Baustein begrenzt durch den Heißsiegelkleber ein. Nach dem Einbau in eine Ausweiskarte liegt der bruchempfindliche IC-Baustein unmittelbar unter der Kontaktmetallschicht, die außenseitig der Karte angeordnet und somit insbesondere beim Kontaktieren Berührungskräften ausgesetzt ist.

Weiterhin ist aus der FR 23 37 381 ein Trägerelement aus einem Isoliermaterialplättchen bekannt, auf dem der IC-Baustein aufgekittet ist und mit Bausteinkontaktstreifen aufkaschiert ist. Der IC-Baustein ist mit einem Kunstharzüberzug ummantelt. Die Bauhöhe des Trägerelements mit dem ummantelten IC-Baustein ist so groß, daß dieser beim Einbringen in eine Ausweiskarte unter Belassung eines Zwischenraumes domartig von einer Folie überspannt wird, die über die Normdicke einer Ausweiskarte hinausragt.

Weiterhin ist es aus der DE 32 48 385 A1 bekannt, in einem Freiraum einer Ausweiskarte ein Trägerelement einzusetzen, wobei der Freiraum mit einer Kittmasse gefüllt ist, die beim Eindrücken des IC-Bausteines in die Kittmasse durch einen schmalen Seitenkanal in einen in der Ausweiskarte belassenen Überlaufraum entweicht.

Weiterhin ist aus der DE 30 29 667 C2 ein derartiges Trägerelement mit einem IC-Baustein bekannt, das in eine Ausnehmung einer Ausweiskarte eingesetzt ist, worauf die Ausnehmung vollständig ausfüllend vergossen ist.

Ein derartiges vergießen ist zwar relativ einfach vorzunehmen, und der Verguß bietet einen gewissen Schutz für den IC-Baustein, jedoch sind das Trägerelement und insbesondere der bruchempfindliche IC-Baustein mit seinen Bondungen durch den Verguß extrem zerstöranfällig, wenn Biegekräfte auf die Ausweiskarte einwirken, da derartige Biegekräfte unmittelbar durch die Vergußmasse auf die eingegossenen Bauteile übertragen werden.

Weiterhin ist aus der EP 0 426 406 A2 ein Trägerelement bekannt, das in einer Vorrichtung mit einem Formkörper mit Formkammern erstellt ist (siehe Präambel des Anspruchs 4), deren Abmessungen allseitig geringer als die entsprechenden Abmessungen der Ausweiskarte sind, so daß jeweils das mit einem gebondeten IC-Baustein zusammen in der Formkammer mit einem Dichtungskunststoff vergossene zentrale IC-Bereich des Trägerelements in der Ausnehmung der Ausweiskarte allseitig beabstandet einzubringen ist. Das Trägerelement besteht vorzugsweise aus Glasfaser-Epoxidharz, und es wird mit einem den vergossenen Zentralbereich übertragenden Randbereich mit einem Siegelharzstreifen in eine Randausnehmung der Ausweiskarte, die aus ABS-Kunststoff besteht, eingekittet.

Weiterhin ist aus der EP 0 344 058 A1 eine Ausweiskarte bekannt (siehe Präambel des Anspruchs 7), in die ein trägerelement randseitig mit einem umlaufenden Siegelstreifen eingekittet wird. Das Trägerelement ist ein Abschnitt aus einem kontaktbildenden Metallstreifen, auf dem ein IC-Chip kontaktiert ist und eine Isolierfolie im Zentralbereich aufgebracht ist. Der IC-Chip mit den Kontakten ist bis randseitig auf den Siegelstreifen reichend mit einem Kunststofftropfen versiegelt, wobei jedoch der Siegelstreifen im übrigen zur damit zuverbindenden Oberfläche der Kartenkörperausnehmung von dem Kunststofftropfen frei gehalten ist.

Es ist Aufgabe der Erfindung, ein Verfahren und eine Vorrichtung zu offenbaren, mit denen auf einfache Weise sowohl ein hoher Schutz eines IC-Bausteines auf einem Trägerelement gegen Umwelteinflüssen als auch ein Schutz gegen Biegekrafteinflüsse nach dessen Einbau in eine Ausweiskarte erbracht werden.

Die Lösung besteht darin, daß das Trägerelement zunächst mit dem aufgekitteten IC-Baustein und den Anschlußbondierungen nach unten in eine mit einer Zweikomponenten-Epoxidharzvergußmasse ganz oder annähernd randvoll gefüllten Formkammer einer Formvorrichtung so eingelegt wird, daß die randseitige Überlappung des Trägerelements auf dem Rand der Formkammer der Formvorrichtung aufliegt, und dann das Trägerelement mit einer Druckplatte abgedeckt wird und damit in die Formvorrichtung so eingepreßt wird, daß die überschüssige Epoxidharzmasse aus der Formkammer seitlich austritt und sich eine sehr dünne Epoxidschicht am Rand der Formkammer auf der randseitigen Überlappung des Trägerelements ausbildet, und dann die gefüllte Formvorrichtung bis zu einer Abbindung der Epoxidharzmasse aufgeheizt und danach das Trägerelement entformt wird.

Die Vorrichtung zur Durchführung des Verfahrens ist im Anspruch 4 gekennzeichnet. Vorzugsweise ist sie als ein Mehrfachwerkzeug ausgestaltet, dessen Formkammern in einem gleichen Raster angeordnet sind, in dem die Trägerelemente auf einem Trägersubstrat als Vielfachnutzen erzeugt werden und mit IC-Bausteinen bestückt werden.

Die mit dem Trägerelement bestückte Ausweiskarte ist im Ansruch 7 gekennzeichnet.

Vorteilhafte Ausgestaltungen sind in den Unteransprüchen angegeben.

Das Verfahren hat sich bei unterschiedlichen Trägermaterialien, z.B. Glasfaserfolie, Polyimidfolie, bewährt, die als elastische, dünne Folienleiterbahn-Basismaterialien handelsüblich sind.

Als Schutzbeschichtungsmaterial des IC-Bausteines hat sich ein Zweikomponenten-Epoxidharz mittlerer Härte bewährt, da es als dünne Schicht gut mit der Trägerfolie abbindet und einen elastischen Übergang und Überzug zu dem IC-Baustein bildet. Die Topfzeit einer solchen Zweikomponenten-Epoxidharzmischung beträgt bei Normalbedingungen mehrere Tage. In der Form bindet die Mischung jedoch bei etwa einer Temperatur von etwa 120° innerhalb von 15 Minuten ab.

Es hat sich als vorteilhaft erwiesen, daß die dünne Schicht des Epoxidharzes, die die Trägerfolie bedeckt, eine wesentlich bessere Haftfähigkeit bei einem nachfolgenden Verkleben des Trägers mit dem Ausweiskartenmaterial aufweist, als ein unbeschichteter Träger.

Daß die Epoxidharzschicht auf dem Trägermaterial außerhalb des IC-Bausteinbereiches nur sehr dünn ist, wird durch die Überschußmaterial-Aufnahmekammern in der Formvorrichtung gewährleistet, in die das Material unter dem Druck der Vorrichtung ausweicht. Nach dem Zusammenpressen kann die Vorrichtung in eine Heizvorrichtung zum Aushärten eingebracht werden.

Die Formvorrichtung läßt sich aus Metall, z. B. Leichtmetall, mit einfachen Mitteln herstellen. Eine derartige Form wird mit einer dünnen Trennfolie aus Silikongummi ausgekleidet, damit das Entformen des gehärteten Epoxidharzes leicht möglich ist.

Eine bevorzugte Ausgestaltung der Formvorrichtung besteht in einer metallplattengestützten Silikongummiform, die auf einem Positivmodell abgeformt ist. Eine derartige Silikongummiform erbringt inhärent die Trennfunktion zu dem Epoxidharz.
Vorteilhafte Ausgestaltungen sind in den Fig. 1 bis 3 dargestellt.
- Fig. 1: zeigt vergrößert einen vertikalen Schnitt durch die Formvorrichtung zur Herstellung der Trägerelemente;
- Fig. 2: zeigt eine Aufsicht auf eine Formvorrichtung für Mehrfachnutzen mit Trägerelementen;
- Fig. 3: zeigt einen Schnitt durch eine Ausweiskarte mit einem Trägerelement mit vergossenem IC-Baustein.

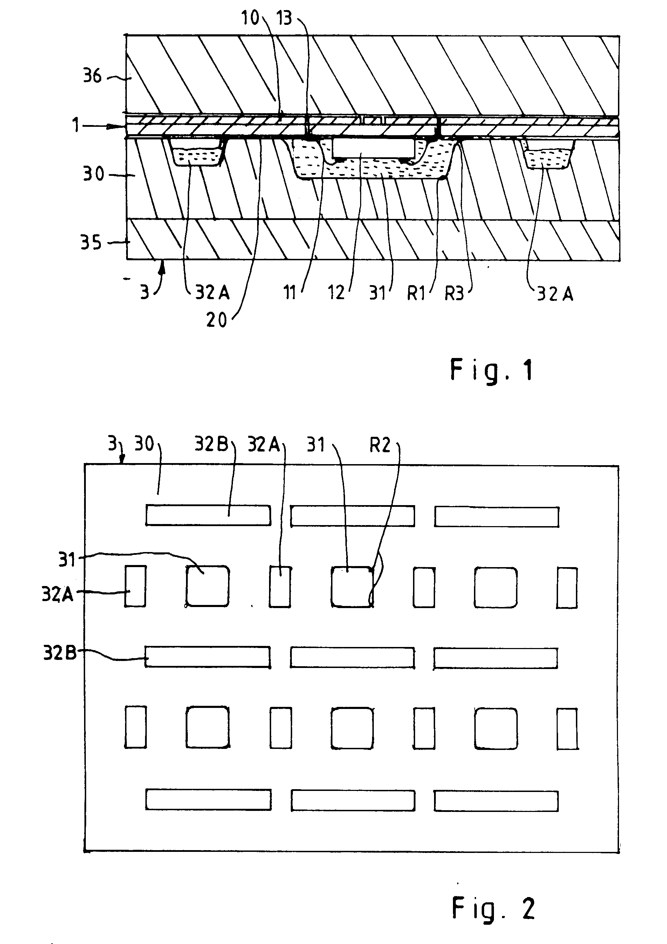

Figur 1 zeigt einen vergrößerten Schnitt durch eine Formvorrichtung (3), die aus einer Basisplatte (35) mit einem Formkörper (30) besteht, in den eine Formkammer (31) eingebracht ist und auf dem das Trägerelement (1) so aufgebracht wird, daß der IC-Baustein (12) mit den Bondverbindungen (11) in die Formkammer hineinragt. Das Trägerelement (1) ist von einer Druckplatte (36) abgedeckt. Außer der Formkammer (31) befinden sich um diese herum Überschußkammern (32A). Diese dienen dazu, in die Formkammer (31) eingebrachtes Zweikomponenten-Epoxidharz aufzunehmen, welches bei dem Eintauchen des IC-Bausteines (12) überschüssig ist und aus der Formkammer (31) seitlich herausgepreßt wird, sobald die Form zwischen den Platten (35, 36) druckmäßig beaufschlagt wird. Hierbei bildet sich eine dünne Epoxidharzschicht (20) zwischen dem Trägerelement (1) und der Oberseite des Formkörpers (30) aus, die bis zu den Überschußkammern (32A) reicht. Der Formkörper (30) ist vorzugweise aus einem Trennmittel für Epoxidharz hergestellt, nämlich aus Silikongummi geeigneter Festigkeit, so daß nach dem Aushärten des Zweikomponenten-Epoxidharzes eine Entformung leicht stattfinden kann. Die Vergußmasse, die den IC-Baustein mit den Bondungen umgibt, bildet einen geschlossenen Vergußmantel (2), welcher in die dünne flexible Epoxidschicht (20) ausläuft, die sehr gut an dem Trägerelement, das aus einer Kunststoffolie besteht, haftet. Um ein leichtes Entformen zu gewährleisten, sind die Formkammern (31) und die Überschußkammern (32A) mit Entformschrägen versehen und entlang ihren Kanten mit konkaven Rundungen (R1, R2) versehen. Auch die randseitigen Übergänge zur dünnen Epoxidschicht (20) sind mit einer konvexen Abrundung (R3) ausgestaltet.

Das Trägerelement (1) ist auf der Oberseite in bekannter Weise mit Kontaktflächen (10) versehen, die entweder direkt durch größere Öffnungen in dem Trägerelement oder durch Durchkontaktierungen (13) mit Bonddrähten (11) an Anschlußkontakte auf dem IC-Baustein (12) angeschlossen sind.

Nachdem die Formkammern (31) mit Epoxidharz gefüllt sind, und die Form mit dem Trägerelement bestückt und mit der Druckplatte (36) abgedeckt ist, wird das überschüssige Epoxidharz in die Überschußkammern (32A) hineingequetscht, und dann wird die gesamte Form etwa eine viertel Stunde lang auf eine Temperatur von 120°C erhitzt, so daß das Epoxidharz reagiert und aushärtet. Nach der Aushärtung wird das Trägerelement (1) entformt und so beschnitten, daß die Teile die die Überschußkammern (32A) überragen entfernt werden.

Figur 2 zeigt eine Formvorrichtung (3) mit einer Aufsicht auf den Formkörper (30), in den mehrere Formkammern (3) in einem Raster angeordnet sind, welches einer entsprechenden Rasteranordnung der Kontaktflächen und der IC-Bausteine auf einem Mehrfachnutzen einer Trägerelementfolie entspricht. Die Formkammern (31) sind jeweils an ihren Längs- und Querseiten mit den Überschußkammern (32A, 32B) umgeben. Durch diese Mehrfachform läßt sich der Vergießvorgang einschließlich des folgenden Aushärtens außerordentlich rationell durchführen.

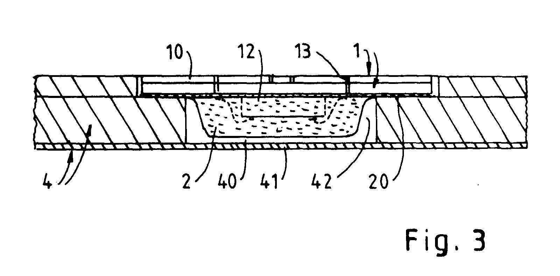

Figur 3 zeigt einen vergrößerten Querschnitt durch eine Ausweiskarte (4) mit einer Ausnehmung (40), welche von einem Trägerelement (1) überdeckt ist, so daß deren Kontaktflächen (10) nach außen weisen und der IC-Baustein (12) mit seinem Epoxid-Vergußmantel (2) in die Ausnehmung (40) eintaucht. Hierbei ist zwischen den Wandungen der Ausnehmung (40) und dem Vergußmantel (2) allseitig ein Spalt (42) belassen, so daß sich Knick- und Scherkräfte von der Ausweiskarte nicht auf den Vergußmantel (2) und damit auch nicht auf den IC-Baustein übertragen. Die dünne Epoxidschicht (20), welche sich seitlich des Vergußmantels (2) auf dem Trägerelement (1) erstreckt, erbringt eine außerordentlich gute Haftung der Verklebung zwischen dem Trägerelement und dem Karteninnenmaterial. Vorzugsweise ist die Ausnehmung (40) mit einer Kaschierfolie (41) oberhalb des Vergußmantels (2) abgedeckt, wobei ein geringer Restspalt zu diesem verbleibt.

## Patentansprüche

1. Verfahren zur Herstellung eines Trägerelementes (1) aus einem kontaktkaschierten Folienmaterial mit einem aufgekitteten und mit Kunststoff umgebenen IC-Baustein (12), der in eine Ausnehmung (40) einer Ausweiskarte (4) unter Freilassung eines allseitigen Spaltes (42) einbaubar ist, wobei die kontaktkaschierte Folie des Trägerelements (1) die Ausnehmung (40) randseitig überlappt, dadurch gekennzeichnet, daß das Trägerelement (1) zunächst mit dem aufgekitteten IC-Baustein (12) und den Anschlußbondierungen (11) nach unten in eine mit einer Zweikomponenten-Epoxidharzvergußmasse ganz oder annähernd randvoll gefüllten Formkammer (31) einer Formvorrichtung (3) so eingelegt wird, daß die randseitige Überlappung des Trägerelements (1) auf dem Rand der Formkammer (31) der Formvorrichtung (3) aufliegt, und dann das Trägerelement (1) mit einer Druckplatte (36) abgedeckt wird und damit in die Formvorrichtung (3) so eingepreßt wird, daß die überschüssige Epoxidharzmasse aus der Formkammer (31) seitlich austritt und sich eine sehr dünne Epoxidschicht (20) am Rand der Formkammer (31) auf der randseitigen Überlappung des Trägerelements (1) ausbildet, und dann die gefüllte Formvorrichtung (3) bis zu einer Abbindung der Epoxidharzmasse aufgeheizt und danach das Trägerelement (1) entformt wird.

2. Verfahren nach Anspruch 1, dadurch gekennzeichnet, daß die Epoxidharzmasse derart aus den zwei Komponenten zusammengesetzt ist, daß ihre Topfzeit bei Normalbedingungen mehrere Tage beträgt und eine Aushärtung bei einer Temperatur von ca. 120° in ca. 15 Minuten erfolgt.

3. Verfahren nach Anspruch 1 oder 2, dadurch gekennzeichnet, daß die Epoxidharzmasse derart aus zwei Komponenten zusammengesetzt ist, daß der ausgehärtete Epoxidharz-Vergußmantel (2) eine mittlere Härte aufweist, und die dünne Epoxidschicht (20) ausgehärtet biegsam ist.

4. Vorrichtung zur Durchführung des Verfahrens nach einem der vorstehenden Ansprüche 1 bis 3, die heizbar ist und aus einem Formkörper (30) besteht, in den Formkammern (31) eingebracht sind, deren Abmessungen allseitig geringer sind, als entsprechende Abmessungen der Ausnehmung (40) der Ausweiskarte (4), und wobei die Formkammer (31) jeweils so bemessen ist, daß sie einen eingebrachten gebondeten IC-Baustein (12) allseitig beabstandet umschließt, dadurch gekennzeichnet, daß der Formkörper (30) zwischen zwei Druckplatten (35, 36) liegt, die auf den Formkörper Druck ausüben können, sämtliche Formkammerkanten konkave Rundungen (R1, R2) aufweisen, die Formkammer (31) seitliche Ausformschrägen aufweist und zur Formkörperoberfläche hin eine konvexe Abrundung (R3) aufweist, und daß um jede Formkammer (31) herum Überschußkammern (32A, 32B) in dem Formkörper (30) angeordnet sind, in die eine herausgepreßte Epoxidharzmasse fließen kann, wobei eine dünne Epoxidschicht zwischen den Formkammern und den Überschußkammern zurückbleibt.

5. Vorrichtung nach Anspruch 4, dadurch gekennzeichnet, daß der Formkörper (30) aus Metall besteht und die Formkammer (31) und die diese randseitig umgebende Formfläche mit einem Trennmittel belegt ist.

6. Vorrichtung nach Anspruch 4, dadurch gekennzeichnet, daß der Formkörper (30) aus Silikongummi besteht und auf einer stabilen Basisplatte (35) angeordnet ist.

7. Ausweiskarte mit einem Trägerelement (1) hergestellt nach dem Verfahren nach einem der Ansprüche 1 bis 3, welches Trägerelement (1) aus einem kontaktkaschierten Folienmaterial besteht, auf dem ein IC-Baustein (12) mit Anschlußbondierungen (11) aufgekittet ist und wobei dieser zusammen mit den Anschlußbondierungen (11) allseitig eingeschlossen von einem Epoxidharz-Vergußmantel (2) mittlerer Härte umgeben ist, dessen sämtliche Kanten abgerundet sind und der in eine dünne, elastischen Epoxidharzschicht (20) allseitig ausläuft, die wie der Epoxidharz-Vergußmantel (2) auf dem Trägerelement haftet, und sein IC-Baustein (12) mit dem Epoxidharz-Vergußmantel (2) in einer Ausnehmung (40) eines Kartenkörpers (4) unter Belassung eines allseitigen Spaltes (42) angeordnet ist, und das Trägerelement (1) die Ausnehmung (40) allseitig überkragt, dadurch gekennzeichnet, daß es auf dem Kartenkörper (4) im Bereich der elastischen Epoxidharzschicht (20) aufgeklebt ist.

8. Ausweiskarte nach Anspruch 7, dadurch gekennzeichnet, daß ihr IC-Baustein (12) mit dem Epoxidharz-Vergußmantel (2) auf der freien Seite der Ausnehmung (40) durch eine Kaschierfolie (41) beabstandet abgedeckt ist.

9. Ausweiskarte nach einem der Ansprüche 7 oder 8, dadurch gekennzeichnet, daß deren Trägerelement (1) aus einer Glasfaserfolie oder einer Polyimidfolie besteht, die mit vergoldeten Kontakten (10) kaschiert ist, die unmittelbar oder mittels Durchkontaktierungen (13) über Anschlußbondierungen (11) mit Kontaktflächen auf dem IC-Baustein (12) verbunden sind.

## Claims

1. Method of producing a support element (1) from a contact-laminated foil material with a cemented and plastics-surrounded IC component (12) which can be fitted into a recess (40) of an identity card (4), leaving open a gap (42) all round, the contact-laminated foil of the support element (1) overlapping the recess (40) at the edge, characterised in that the support element (1) at first with the cemented IC component (12) and the terminal bonding points (11) is so inserted downward into a moulding chamber (31) - of a moulding device - filled to the brim entirely or almost with a two-component epoxy resin casting compound, that the peripheral overlapping of the support element (1) rests on the edge of the moulding chamber (31) of the moulding device (3) and then the support element (1) is covered with a pressure plate (36) and is thereby so pressed into the moulding device that the excess epoxy resin compound comes out of the edges of the moulding chamber (31) on the peripheral overlap of the support element (1), and then the filled moulding device (3) is heated until setting ofthe epoxy resin compound, and thereafter the support element (1) is removed from the mould.

2. Method according to claim 1, characterised in that the epoxy resin compound is composed of the two components in such a manner that its pot life in normal conditions is several days, and hardening takes place at a temperature of about 120° in approx. 15 minutes.

3. Method according to claim 1 or 2, characterised in that the epoxy resin compound is so composed of 2 components that the hardened epoxy resin moulding surface (2) has an average hardness and the thin epoxy resin layer (20) is flexible when hardened.

4. Apparatus for carrying out the method according to one of claims 1-3, which is heatable and consists of moulding body (30) in which moulding chambers (31) are formed, whose dimensions are less all round than the corresponding dimensions of the recess (40) of the identity card (4), and wherein the respective moulding chamber is so dimensioned that it encloses on all sides with clearance an inserted, bonded IC component (12), characterised in that the moulding body (30) lies between two pressure plates (35, 36) which can exert pressure on the moulding body, all the moulding chamber edges have concave rounded portions (R1, R2), the moulding chamber (31) has lateral shaping slopes and a convex rounded portion (R3) towards the moulding body surface, and in that around each moulding chamber (31), overflow chambers (32A, 32B) are disposed in the moulding body (30), into which epoxy resin compound that is squeezed out can flow, with a thin epoxy resin layer being left between the moulding chambers and the overflow chambers.

5. Apparatus according to claim 4, characterised in that the moulding body (30) consists of metal and the moulding chamber (31) and the moulding face surrounding the moulding chamber at the edges is equipped with a separating means.

6. Apparatus according to claim 4, characterised in that the moulding body (30) consists of silicone rubber and is disposed on a stable base plate (35).

7. Identity card with a support element (1) produced according to the method according to one of claims 1 to 3, which support element (1) consists of a contact-laminated foil material, on which an IC component (12) is cemented with terminal bonding points (11) and is surrounded on all sides so as to be enclosed bv an epoxy resin casting jacket (2) of average hardness, all of whose edges are rounded and which runs out on all sides in a thin, resilient epoxy resin layer, which adheres to the support element like the epoxy resin casting jacket (2), and its IC component (12) is disposed with the epoxy resin casting jacket (2) in a recess (40) of a card body (4), leaving an all-round gap (42), and the support element (1) overlaps the recess (40) all round, characterised in that it is adhered to the card body (4) in the region of the resilient epoxy resin laver (20).

8. Identity card according to claim 7, characterised in that its IC component (12) with the epoxy resin casting jacket (2) is covered on the open side ofthe recess (40) by a laminated foil (41).

9. Identity card according to either of claims 7 or 8, characterised in that its support element (1) consists of a fibre-glass foil or a polyamide foil, which is laminated with gilt contacts (10), which are connected to the contact surfaces on the IC component (12) directly or by means of through-contacts (13) via terminal bonding points (11).

## Revendications

1. Procédé de fabrication d'un élément de support (1) composé d'une feuille doublée de contacts et d'un module à circuit intégré (12) y fixé et entouré de matière synthétique, lequel peut être placé dans un évidement (40) d'une carte d'identité (4) en laissant un espace libre (42) la feuille doublée de contacts de l'élément de support (1) chevauchant marginalement l'évidement (40),
caractérisé en ce que
l'élément de support (1) est d'abord mis en place, le module à circuit intégré (12) y fixé et les soudures de raccordement (11) étant dirigés vers le bas, dans une chambre de moulage (31) du dispositif de moulage (3) qui est remplie complètement ou presque jusqu'au bord d'une masse résineuse époxy à deux composants de sorte que le chevauchement marginal de l'élément de support (1) repose sur le rebord de la chambre (31) du dispositif de moulage (3), ce après quoi l'élément de support (1) est recouvert d'une plaque de compression (36) et pressé ainsi dans le dispositif de moulage (3) de sorte que l'excédent de masse résineuse époxy à sceller sorte latéralement de la chambre de moulage (31) et qu'une couche d'époxy très fine (20) se forme sur le rebord de la chambre de moulage (31) sur le chevauchement marginal de l'élément de support (1), le dispositif de moulage (3) ainsi rempli étant ensuite chauffé jusqu'à la prise de la masse résineuse époxy, ce après quoi l'élément de support (1) est démoulé.

2. Procédé selon la revendication 1,
caractérisé en ce que
la masse résineuse époxy à deux composants est constituée de sorte que sa durée de conservation comporte plusieurs jours dans des conditions normales et qu'un durcissement se produise en 15 minutes environ à une température d'environ 120° C.

3. Procédé selon la revendication 1 ou 2,
caractérisé en ce que
la masse résineuse époxy a deux composants est constituée de sorte que le manteau de scellement en résine époxy durci (2) présente une dureté moyenne et que la fine couche d'époxy (20) durcie est flexible.

4. Dispositif pour l'exécution du procédé selon l'une des revendications précédentes 1 à 3, lequel peut être chauffé et est composé d'un corps de moulage (30) dans lequel des chambres de moulage (31) sont pratiquées, leurs dimensions étant, de toutes parts, inférieures aux dimensions correspondantes de l'évidement (40) de la carte d'identité (4) et chaque chambre de moulage (31) étant dimensionnée de sorte a entourer à distance, de toutes parts, le module à circuit intégré (12),
caractérisé en ce que
le corps de moulage (30) est placé entre deux plaques de compression (35, 36) qui exercent sur lui une pression, que tous les bords des chambres de moulage présentent des arrondissements concaves (R1, R2), que chaque chambre de moulage (31) présente des surfaces latérales obliques pour le démoulage et un arrondissement convexe (R3) en direction de la surface du corps du moule, et que des chambres de trop-plein (32A, 32B), disposées autour de chaque chambre de moulage (31), sont pratiquées dans le corps du moule (30) pour accueillir l'excédent de masse résineuse époxy, une fine couche de résine époxy demeurant entre les chambres de moulage et les chambres de trop-plein.

5. Dispositif selon la revendication 4,
caractérisé en ce que
le corps du moule (30) est exécuté en métal et que la chambre de moulage (31) et la surface de moulage l'entourant sur les côtés sont pourvues d'un agent séparateur.

6. Dispositif selon la revendication 4,
caractérisé en ce que
le corps du moule (40) est exécuté en caoutchouc silicone et disposé sur une plaque de base (35) solide.

7. Carte d'identité avec un élément de support (1), exécutée conformément au procédé selon les revendications 1 à 3, cet élément de support (1) consistant en une matière pelliculaire doublée sur laquelle un module à circuit intégré (12) est fixé par des soudures de raccordement (11) un manteau de scellement en résine époxy (2) de dureté moyenne recouvrant de toutes parts le module à circuit intégré et les soudures de raccordement, tous les bords de ce manteau étant arrondies et le manteau de scellement s'épandant de tous côtés en une fine couche de résine époxy (20) qui, tout comme le manteau de scellement (2) lui-même, adhère à l'élément de support,
et son module à circuit intégré (12) étant disposé avec le manteau de scellement en résine époxy (2) dans un évidement (40) d'un corps de carte (4) en laissant un espace libre de tous côtés, et l'élément de support (1) dépassant de tous côtés l'évidement (40),
caractérisée en ce que
celui-ci est collé sur le corps de carte (4) dans la zone élastique de la couche de résine époxy (20).

8. Carte d'identité selon la revendication 7,
caractérisée en ce que
son module à circuit intégré (12) y compris le manteau de scellement en résine époxy (2) est recouvert, du côté libre de l'évidement (40), par une feuille (40) distancée.

9. Carte d'identité selon la revendication 7 ou 8,
caractérisée en ce que
son élément de support (1) consiste en une feuille de fibres de verre ou de polyimide, doublée de contacts plaqués d'or (10) qui sont reliés, directement ou indirectement à l'aide d'intermédiaires (13), par des soudures de raccordement (11), à des surfaces de contact sur le module à circuit intégré (12).
